# EUROPEAN PATENT APPLICATION

(11) **EP 4 276 128 A1**
(43) Date of publication of application: **15.11.2023**
(21) Application number: 22736769.5
(22) Date of filing: 06.01.2022
(51) Int. Cl.: C08G 59/40, H01L 23/29, H01L 23/31, C08L 63/00, C08K 3/013, C08K 3/26

(54) **SEALING COMPOSITION AND SEMICONDUCTOR DEVICE**

(30) Priority: 08.01.2021 JP 2021002322
(71) Applicant: Resonac Corporation, Tokyo 105-8518 (JP)
(72) Inventor: KANG, Dongchul, Tokyo 100-6606 (JP); INOUE, Yoriko, Tokyo 100-6606 (JP)
(74) Representative: Becker, Eberhard
(86) International application number: PCT/JP2022/000275
(87) International publication number: WO 2022/149601

(57) **Abstract**

This sealing composition includes an epoxy resin, a curing agent, an inorganic filler, and an unfired hydrotalcite compound in which the molar ratio (Mg/Al) of Mg ions and Al ions exceeds 3.0.

## Description

### [Technical Field]

The present invention relates to a sealing composition and a semiconductor device.

### [Background Art]

Although gold was used as a material for wires in semiconductor packages in most cases in the past, the skyrocketing price of gold in recent years has led to increasing use of copper as a material for wires. In the meantime, as a sealing composition for sealing a semiconductor package, one containing an epoxy resin has been widely used. However, an epoxy resin is mostly synthesized by using epichlorohydrin, and base residues derived from an epoxy resin tend to remain in sealing compositions containing such epoxy resins as impurities that corrode wires. Because copper is more chemically reactive than gold, it is more susceptible to corrosion by chlorine. Thus, in order to improve the reliability of a semiconductor package in which copper wires are used, it has been attempted to incorporate a hydrotalcite compound as an ion trapping agent for trapping impurity ions in a sealing composition (e.g., refer to Patent Literature 1 and Patent Literature 2).

### [Citation List]

### [Patent Literature]

[Patent Literature 1]
   Japanese Patent Laid-Open No. 2005-1902
[Patent Literature 2]
   Japanese Patent Laid-Open No. 2009-29919

### [Summary of Invention]

### [Technical Problem]

It has been clarified as a result of study by the present inventors that a semiconductor device manufactured by using a semi-fired hydrotalcite compound and a fired hydrotalcite compound disclosed in Patent Literature 1 and Patent Literature 2 has room for improving moisture resistance reliability in a bias-applied state.

Taking the above circumstances into consideration, an objective of the present disclosure is to provide a sealing composition that enables a semiconductor device having excellent moisture resistance reliability in a bias-applied state and electrical reliability in exposure to a high temperature to be manufactured and a semiconductor device using the sealing composition.

### [Solution to Problem]

The following aspects are included in means to solve the problem.
<1> A sealing composition including an epoxy resin, a curing agent, an inorganic filler, and an unfired hydrotalcite compound in which a molar ratio of Mg ions to Al ions (Mg/Al) exceeds 3.0.
<2> A sealing composition including an epoxy resin, a curing agent, an inorganic filler, and an unfired hydrotalcite compound having a maximum particle size of 20 µm or less in which a molar ratio of Mg ions to Al ions (Mg/Al) is 2.5 or higher.
<3> The sealing composition described in <2> in which the molar ratio of Mg ions to Al ions (Mg/Al) of the unfired hydrotalcite compound is 3.0 or higher.
<4> The sealing composition described in <1> in which the maximum particle size of the unfired hydrotalcite compound is 20 µm or less.
<5> The sealing composition described in any one of <1> to <4> in which the interlayer distance of ions in the unfired hydrotalcite compound is 7.7 Å or greater.
<6> A semiconductor device including an element, and a cured product of the sealing composition described in any one of <1> to <5> sealing the element.

### [Advantageous Effects of Invention]

According to the present disclosure, a sealing composition that enables a semiconductor device having excellent moisture resistance reliability in a bias-applied state and electrical reliability in exposure to a high temperature to be manufactured and a semiconductor device using the sealing composition can be provided.

### [Description of Embodiments]

Embodiments for implementing the present invention will be described in detail below. However, the present invention is not limited only to the embodiments. In the embodiments described below, constituent elements thereof (including elemental steps and the like) are not essential unless specified otherwise. The same applies to numerical values and ranges thereof, which do not limit the present invention.

The term "process" in the present disclosure includes not only a process independent from other processes but also a process that is hard to be clearly distinguished from other processes as long as they achieve their purposes.

In numerical value ranges indicated using "...to..." in the present disclosure, the numerical values marked before and after "...to..." are included as a minimum value and a maximum value, respectively.

In numerical value ranges expressed in steps in the present disclosure, the upper limit value or the lower limit value denoted in one numerical value range may be replaced with the upper limit values or the lower limit values of other numerical value ranges expressed in steps. In addition, in a numerical value range described in the present disclosure, the upper limit value or the lower limit value of the numerical value range may be replaced with values shown in examples.

Each component in the present disclosure may include multiple kinds of the corresponding substance. In a case where a composition contains multiple kinds of the substance corresponding to each component, a proportional content or a content amount of each component means a total proportional content or a total content amount of the substance of the multiple kinds contained in the composition unless stated otherwise.

Multiple kinds of particles corresponding to each component may be included in the present disclosure. In a case where a composition contains multiple kinds of particles corresponding to each component, a particle size of each component means a value with respect to a mixture of the multiple kinds of particles contained in the composition unless stated otherwise.

With respect to the term "layer" in the present disclosure, a situation in which a region with a layer formed is observed includes not only a case where the layer is formed in the entire region but also a case where the layer is formed only in a part of the region.

### <Sealing composition of first embodiment>

A sealing composition according to an embodiment of the present disclosure includes an epoxy resin, a curing agent, an inorganic filler, and an unfired hydrotalcite compound in which the molar ratio of Mg ions to Al ions (the Mg/Al ratio) exceeds 3.0 (which will also be referred to as a "first hydrotalcite compound below). The sealing composition according to the first embodiment may include other components such as a curing accelerator.

A semiconductor device manufactured by using the sealing composition according to the first embodiment has excellent moisture resistance reliability in a bias-applied state and electrical reliability in exposure to a high temperature. Although the reasons for this are not clear, they can be presumed as follows. A first hydrotalcite compound included in the sealing composition of the first embodiment is unfired and has a Mg/Al ratio exceeding 3.0. For this reason, the interlayer distance between hydroxide sheets in the first hydrotalcite compound can be widened, and therefore, it is thought that a satisfactory ion trapping effect can be obtained.

It is generally thought that, since aluminum ions are more likely to trap chloride ions in an aqueous solution than magnesium ions, the proportion of Al in the hydrotalcite compound is raised to increase the positive charge of the hydroxide sheets and thus the ion trapping effect can be improved. In the meantime, it is thought that the ion trapping effect can be improved by bringing the value of the Mg/Al ratio into a wider range as described above by lowering the proportion of Al in the hydrotalcite compound among solid materials such as a cured product of the sealing composition of the first embodiment. The reason for this is presumed that the ion trapping effect can be further improved by setting the value of the Mg/Al ratio to be in a wider range as described above to widen the interlayer distance between the hydroxide sheets to improve the trapping ability when anions collide with each other, rather than increasing the proportion of aluminum ions to increase the electrical attraction of anions such as chloride ions. Furthermore, since the structure in which anions such as chloride ions are trapped between the hydroxide sheets is a stable one, it is presumed that the trapped anions are not easily desorbed even when the interlayer distance between the hydroxide sheets becomes longer.

Furthermore, the sealing composition of the first embodiment preferably includes the first hydrotalcite compound having the maximum particle size of 20 µm or less in a particulate form. Thus, it is presumed that the dispersibility of the first hydrotalcite compound in the sealing composition is improved and the ion trapping effect is further improved by raising the probability of collision of anions such as chloride ions with the first hydrotalcite compound when the sealing composition is a cured product.

Components contained in the sealing composition of the first embodiment will be described below.

### (Epoxy resin)

The sealing composition of the first embodiment contains an epoxy resin. The type of epoxy resin is not particularly limited, and a known epoxy resin can be used.

Specifically, examples thereof include, for example, epoxidized novolac resins obtained by condensing or co-condensing, under an acidic catalysis, at least one selected from the group consisting of phenolic compounds (e.g., phenol, cresol, xylenol, resorcinol, catechol, bisphenol A, and bisphenol F) and naphthol compounds (e.g., α-naphthol, β-naphthol and dihydroxynaphthalene), and aldehyde compounds (e.g. formaldehyde, acetaldehyde, propionaldehyde, benzaldehyde and salicylaldehyde); at least one diglycidyl ether selected from the group consisting of bisphenols (e.g. bisphenol A, bisphenol AD, bisphenol F, and bisphenol S) and biphenols (e.g. alkyl-substituted or unsubstituted biphenols); epoxidized products of phenol-aralkyl resins; epoxidized products which are adducts or polyadducts of phenol compounds and at least one selected from the group consisting dicyclopentadiene and terpene compounds; glycidyl ester type epoxy resins obtained by reaction of polybasic acids (e.g. phthalic acid and dimer acid) and epichlorohydrin; glycidylamine type epoxy resins obtained by reaction of polyamines (e.g., diaminodiphenylmethane and isocyanuric acid) with epichlorohydrin; linear aliphatic epoxy resins obtained by oxidation of olefinic bonds with peracids (e.g. peracetic acid); and alicyclic epoxy resins. One type of epoxy resin may be used alone, or two or more types thereof may be used in combination.

From the viewpoint of preventing corrosion of aluminum or copper wires on elements such as integrated circuits (ICs), the epoxy resin preferably has a high purity and a low hydrolyzable chlorine content. From the viewpoint of improving the moisture resistance of the sealing composition, the hydrolyzable chlorine content is preferably 500 ppm or less on a mass basis.

Here, the hydrolyzable chlorine content is a value obtained by dissolving 1 g of a sample epoxy resin in 30 ml of dioxane, adding 5 ml of 1 N-KOH methanol solution, refluxing it for 30 minutes, and then performing potentiometric titration.

### (Curing agent)

The sealing composition of the first embodiment contains a curing agent. The type of curing agent is not particularly limited, and a known curing agent can be used.

Specifically, examples thereof include, for example, a novolac resin obtained by condensing or co-condensing, under an acidic catalyst, at least one selected from the group consisting of phenol compounds (e.g., phenol, cresol, resorcinol, catechol, bisphenol A, and bisphenol F) and naphthol compounds (e.g., α-naphthol, β-naphthol, and dihydroxynaphthalene), and an aldehyde compound (e.g., formaldehyde); phenol-aralkyl resins; and naphthol-aralkyl resins. One type of curing agent may be used alone, or two or more types thereof may be used in combination. Among these, the curing agent is preferably a phenol-aralkyl resin from the viewpoint of improving reflow resistance.

It is preferred that the curing agent be incorporated so that the number of equivalents of the functional group of the curing agent (e.g., the phenolic hydroxyl group in the case of a novolac resin) is 0.5 to 1.5 equivalents with respect to one equivalent of the epoxy groups of the epoxy resin, and it is particularly preferred that the curing agent be incorporated so that the number of equivalents of the functional group is 0.7 to 1.2 equivalents thereto.

### (Inorganic filler)

The sealing composition of the first embodiment includes an inorganic filler. The sealing composition tends to have reduced hygroscopic properties and improved strength in a cured state when it includes an inorganic filler. It is assumed that, in the sealing composition of the first embodiment, the first hydrotalcite compound is not included in the inorganic filler.

Examples of the inorganic filler include fused silica, crystalline silica, alumina, zircon, magnesium oxide, calcium silicate, calcium carbonate, potassium titanate, silicon carbide, silicon nitride, boron nitride, beryllia, and zirconia. Furthermore, examples of an inorganic filler material with flame retardant effects include aluminum hydroxide, composite metal hydroxide, zinc borate, and zinc molybdate. Among these, fused silica is preferred from the viewpoint of a reduction in a linear expansion coefficient, and alumina and boron nitride are preferred from the viewpoint of high thermal conductivity.

One type of inorganic filler may be used alone, or two or more types thereof may be used in combination. Examples of the combined use of two or more inorganic fillers include the use of two or more inorganic fillers having different components, maximum particle sizes, shapes, and the like.

A form of the inorganic filler is not particularly limited, and examples thereof include powder, spherical, and fibrous. A spherical shape is preferred from the viewpoint of fluidity during molding of the sealing composition and mold wear resistance.

From the viewpoint of hygroscopicity, reduction of the linear expansion coefficient, improvement of strength, and soldering heat resistance, the amount of the inorganic filler which is incorporated is in the range of 75% by mass to 97% by mass, preferably in the range of 80% by mass to 95% by mass, and even more preferably in the range of 90% by mass to 95% by mass with respect to the entire sealing composition of the first embodiment.

### (First hydrotalcite compound)

The sealing composition of the first embodiment includes the first hydrotalcite compound.

The first hydrotalcite compound means an unfired hydrotalcite compound in which the Mg/Al ratio exceeds 3.0 in the present disclosure. The Mg/Al ratio is preferably 3.2 or higher, and more preferably 3.5 or higher. An upper limit of the Mg/Al ratio is not particularly limited, and for example, may be 4.0 or lower.

The first hydrotalcite compound is preferably an unfired hydrotalcite compound represented by the following general formula (1).

Mg₁₋ₓAlₓ(OH)₂(CO₃)_{x/2} · mH₂O General formula (1)

[In formula (1), x and m each represent an independent positive number, and the value of (1-x/x) exceeds 3.0]

In general formula (1), x represents a positive number indicating an amount of Mg substituted with Al, and 0 < x < 0.25 is preferred, and 0.2 ≤ x ≤ 0.23 is more preferred. m is a positive number equal to or greater than zero.

The first hydrotalcite compound preferably has a structure in which a plurality of hydroxide sheets represented by [Mg₁₋ₓAlₓ(OH)₂] is stacked in layers and anions (carbonate ions) and water molecules are contained between a hydroxide sheet and another hydroxide sheet (between layers). The hydroxide sheets are positively charged as a whole because part of the divalent metal (Mg) is replaced with the trivalent metal (Al). It is thought that electrostatic balance is kept due to anions taken in between the layers. Due to this property, it is thought that, if the first hydrotalcite compound is the unfired hydrotalcite compound represented by general formula (1), the compound effectively functions as an ion trapping agent in the sealing composition of the first embodiment.

Whether the first hydrotalcite compound is unfired can be verified in X-ray diffraction analysis. In other words, when the peaks of the 001 plane and the 002 plane that are peaks in the layer direction are observed together in X-ray diffraction analysis, the hydrotalcite compound is determined to be unfired. More specifically, when the peaks of the 001 plane and the 002 plane that are peaks in the layer direction are observed together at approximately equal intervals around 5° to 45° in X-ray diffraction, the first hydrotalcite compound is determined to be unfired.

A manufacturing method for the first hydrotalcite compound is not particularly limited, and it can be synthesized in a general method. A Mg/Al ratio of the first hydrotalcite compound can be set to a desired value, for example, by adjusting the molar ratio of Mg salt and Al salt to be used as raw materials.

A Mg/Al ratio of the first hydrotalcite compound included in the sealing composition or a cured product can be measured by using, for example, energydispersive X-ray spectroscopy (EDX).

The first hydrotalcite compound preferably has the maximum particle size of 20 µm or less in a particulate form. A lower limit of the maximum particle size of the first hydrotalcite compound is not particularly limited. When the first hydrotalcite compound is in the form of secondary particles, the above maximum particle size represents the maximum particle size of secondary particles.

In the present disclosure, the maximum particle size of the first hydrotalcite compound is the maximum value among the measured longer diameters of 10 randomly selected first hydrotalcite compounds in an image obtained by imaging a sample of the sealing composition or its cured product with a scanning electron microscope. Alternatively, even if the first hydrotalcite compounds can be detected by energy dispersive X-ray spectroscopy (EDX), if the first hydrotalcite compound is not able to be identified in the detected region in the image captured with the scanning electron microscope, the maximum particle size of the first hydrotalcite compound is determined to be 20 µm or less. In addition, when measuring the hydrotalcite compound alone using a particle size distribution meter, the particle size is measured using a laser diffraction particle size distribution meter (manufactured by Horiba, Ltd., LA920), and the peak particle size (the largest peak particle size if there are multiple peak particle sizes) is determined as the maximum particle size.

If the first hydrotalcite compound in the sealing composition of the present disclosure is in the form of secondary particles and the maximum particle size of the secondary particles is 20 µm or less, the primary particle size of the first hydrotalcite compound used to prepare the sealing composition is preferably 50 nm or greater. Thus, secondary aggregation of the first hydrotalcite compound is mitigated, and the maximum particle size of the secondary particles is easily adjusted to 20 µm or less.

The specific surface area of the first hydrotalcite compound is preferably 10 m²/g to 100 m²/g, more preferably 10 m²/g to 80 m²/g.

The specific surface area of the first hydrotalcite compound is a value measured by using the BET method.

From the viewpoint of ion trapping effects, the interlayer distance of ions in the unfired hydrotalcite compound is preferably 7.7 Å or more, more preferably 7.8 Å or more. The interlayer distance of ions in the unfired hydrotalcite compound is not particularly limited, and may be, for example, 9.0 Å or less.

The interlayer distance of ions in the unfired hydrotalcite compound can be calculated using Bragg's equation.

The proportional content of the first hydrotalcite compound in the sealing composition of the first embodiment is not particularly limited. From the viewpoint of realizing sufficient moisture resistance reliability, the content amount of the first hydrotalcite compound is preferably 1 part by mass or more with respect to 100 parts by mass of the epoxy resin in the sealing composition of the first embodiment. From the viewpoint of sufficiently exhibiting the effects of the other components, the content amount of the first hydrotalcite compound is 15 parts by mass or less, more preferably 10 parts by mass or less, and even more preferably 8 parts by mass or less with respect to 100 parts by mass of the epoxy resin in the sealing composition of the first embodiment.

The first hydrotalcite compound contained in the sealing composition of the first embodiment may be of one type or two or more types. Examples of the case in which two or more types of first hydrotalcite compounds are included include a case in which two or more types of first hydrotalcite compounds with a different Mg/Al ratio, maximum particle size, specific surface area, and the like are included. In addition, the unfired first hydrotalcite compound may be combined with a fired hydrotalcite compound. The fired hydrotalcite compound does not have a structure in which a plurality of hydroxide sheets represented by [Mg₁₋ₓAlₓ(OH)₂] is stacked in layers, and its specific surface area is preferably larger than that of the first hydrotalcite compound.

The first hydrotalcite compound also includes compounds in which one or both of the Mg element and the Al element are partially replaced with other metal elements as long as the effects of the invention of the present specification are achieved.

### (Curing accelerator)

The sealing composition of the first embodiment may further contain a curing accelerator.

The type of curing accelerator is not particularly limited, and examples thereof include cyclic amidine compounds such as diaza-bicyclo alkene such as 1,5-diazabicyclo[4.3.0]nonene-5 (DBN) and 1,8-diazabicyclo[5.4.0]undecene-7 (DBU), 2-methylimidazole, 2-phenylimidazole, 2-phenyl-4-methylimidazole, and 2-heptadecylimidazole; derivatives of the cyclic amidine compounds; a phenol novolac salt of the cyclic amidine compounds or derivatives thereof; compounds with intramolecular polarization obtained by adding, to the above-described compounds, compounds with π bonds such as maleic anhydride, a quinone compound such as 1,4-benzoquinone, 2,5-toluquinone, 1,4-naphthoquinone, 2,3-dimethylbenzoquinone, 2,6-dimethylbenzoquinone, 2,3-dimethoxy-5-methyl-1,4-benzoquinone, 2, 3-dimethoxy-1,4-benzoquinone, and phenyl-1,4-benzoquinone, and diazophenylmethane; cyclic amidinium compounds such as a tetraphenylborate salt of DBU, a tetraphenylborate salt of DBN, a tetraphenylborate salt of 2-ethyl-4-methylimidazole, and a tetraphenylborate salt of N-methylmorpholine; tertiary amine compounds such as pyridine, triethylamine, triethylenediamine, benzyldimethylamine, triethanolamine, dimethylaminoethanol, and tris(dimethylaminomethyl)phenol; derivatives of the tertiary amine compounds; ammonium salt compounds such as tetra-n-butylammonium acetate, tetra-n-butylammonium phosphate, tetraethylammonium acetate, tetra-n-hexylammonium benzoate, and tetrapropylammonium hydroxide; organic phosphines such as primary phosphines such as ethylphosphine and phenylphosphine, secondary phosphines such as dimethylphosphine and diphenylphosphine, tertiary phosphines such as triphenylphosphine, diphenyl(p-tolyl)phosphine, tris(alkylphenyl)phosphine, tris(alkoxyphenyl)phosphine, tris(alkylalkoxyphenyl)phosphine, tris(dialkylphenyl)phosphine, tris(trialkylphenyl)phosphine, tris(tetraalkylphenyl)phosphine, tris(dialkoxyphenyl)phosphine, tris(trialkoxyphenyl)phosphine, tris(tetraalkoxyphenyl)phosphine, trialkylphosphine (tributylphosphine, etc.), dialkylarylphosphine, alkyldiarylphosphine, trinaphthylphosphine, and tris(benzyl)phosphine; phosphine compounds such as complexes of the above organic phosphines and organic borons; compounds with intramolecular polarization obtained by adding the organic phosphines or the phosphine compounds and maleic anhydride and compounds with π bonds such as quinone compounds such as 1,4-benzoquinone, 2,5-toluquinone, 1,4-naphthoquinone, 2,3-dimethylbenzoquinone, 2,6-dimethylbenzoquinone, 2,3-dimethoxy-5-methyl-1,4-benzoquinone, 2, 3-dimethoxy-1,4-benzoquinone, phenyl-1,4-benzoquinone, and anthraquinone, and diazophenylmethane; compounds having intramolecular polarization obtained through a dehydrohalogenation step after reacting the organic phosphine or the phosphine compound with a halogenated phenol compound such as 4-bromophenol, 3-bromophenol, 2-bromophenol, 4-chlorophenol, 3-chlorophenol, 2-chlorophenol, 4-iodinated phenol, 3-iodinated phenol, 2-iodinated phenol, 4-bromo-2-methylphenol, 4-bromo-3-methylphenol, 4-bromo-2,6-dimethylphenol, 4-bromo-3,5-dimethylphenol, 4-bromo-2,6-di-t- butylphenol, 4-chloro-1-naphthol, 1-bromo-2-naphthol, 6-bromo-2-naphthol, and 4-bromo-4'-hydroxybiphenyl; tetrasubstituted phosphonium compounds such as tetrasubstituted phosphonium such as tetraphenylphosphonium, tetraphenylborate salts of tetrasubstituted phosphonium such as tetraphenylphosphonium tetra-p-tolylborate, and salts of tetrasubstituted phosphonium and phenol compounds; phosphobetaine compounds; adducts of phosphonium compounds and silane compounds; and the like. Among these, triphenylphosphine and an adduct of triphenylphosphine and a quinone compound are preferred.

One type of curing accelerator may be used alone, or two or more types thereof may be used in combination.

The proportional content of the curing accelerator is preferably 0.1 % by mass to 8% by mass with respect to the total amount of the epoxy resin and curing agent.

### (Ion trapping agent)

The sealing composition of the first embodiment may further include an ion trapping agent in addition to the first hydrotalcite compound. Examples of ion trapping agent include a compound represented by the following general formula (2).

BiOₓ(OH)_{y}(NO3)_{z} General formula (2)

In general formula (2), x is 0.9 ≤ x ≤ 1.1, y is 0.6 ≤ y ≤ 0.8, and z is 0.2 ≤ z ≤ 0.4. The compound represented by general formula (2) is available, for example, under the trade name IXE 500 from Toagosei Co., Ltd.

When the sealing composition of the first embodiment contains an ion trapping agent in addition to the first hydrotalcite compound, the proportional content of the first hydrotalcite compound in the total ion trapping agent is preferably 30% by mass or more, more preferably 40% by mass or more, and even more preferably 50% by mass or more.

### (Coupling agent)

The sealing composition of the first embodiment may further contain a coupling agent. The type of coupling agent is not particularly limited, and a known coupling agent can be used. Examples of coupling agent include a silane coupling agent and a titanium coupling agent. One type of coupling agent may be used alone, or two or more types thereof may be used in combination.

Examples of the silane coupling agent include vinyltrichlorosilane, vinyltriethoxysilane, vinyltris(β-methoxyethoxy)silane, γ-methacryloxypropyltrimethoxysilane, β-(3,4-epoxycyclohexyl)ethyltrimethoxysilane, γ-glycidoxypropyltrimethoxysilane, vinyltriacetoxysilane, γ-mercaptopropyltrimethoxysilane, γ-aminopropyltriethoxysilane, γ-[bis(β-hydroxyethyl)]aminopropyltriethoxysilane, N-β-(aminoethyl)- γ-aminopropyltrimethoxysilane, γ-(β-aminoethyl)aminopropyldimethoxymethylsilane, N-(trimethoxysilylpropyl)ethylenediamine, N-(dimethoxymethylsilylisopropyl)ethylenediamine, methyltrimethoxysilane, methyltriethoxysilane, N-β-(N-vinylbenzylaminoethyl)-γ-aminopropyltrimethoxysilane, γ-chloropropyltrimethoxysilane, hexamethyldisilane, γ-anilinopropyltrimethoxysilane, vinyltrimethoxysilane, and γ-mercaptopropylmethyldimethoxysilane.

Examples of the titanium coupling agent include isopropyl triisostearoyl titanate, isopropyl tris(dioctylpyrophosphate) titanate, isopropyl tri(N-aminoethyl-aminoethyl) titanate, tetraoctylbis(ditridecylphosphite) titanate, tetra(2,2-diallyloxymethyl-1-butyl)bis(ditridecylphosphite)titanate, bis(dioctylpyrophosphate)oxyacetate titanate, bis(dioctylpyrophosphate)ethylene titanate, isopropyltrioctanoyltitanate, isopropyldimethacryl isostearoyl titanate, isopropyl tridodecylbenzenesulfonyl titanate, isopropyl isostearoyl diacryl titanate, isopropyl tri(dioctylphosphate) titanate, isopropyltricumylphenyl titanate, and tetraisopropyl bis(dioctylphosphite) titanate.

When the sealing composition of the first embodiment contains a coupling agent, the proportional content of the coupling agent is preferably 3% by mass or less with respect to the entire sealing composition of the first embodiment, and preferably 0.1% by mass or more from the viewpoint of exhibiting the effects.

### (Mold release agent)

The sealing composition of the first embodiment may further contain a mold release agent. The type of mold release agent is not particularly limited, and a known mold release agent can be used. Specific examples thereof include higher fatty acids, carnauba wax, and polyethylene-based waxes. One type of mold release agent may be used alone, or two or more types thereof may be used in combination.

When the sealing composition of the first embodiment contains a mold release agent, the proportional content of the mold release agent is preferably 10% by mass or less with respect to the total amount of the epoxy resin and the curing agent, and preferably 0.5% by mass or more from the viewpoint of exhibiting the effects.

### (Colorant and modifier)

The sealing composition of the first embodiment may contain a colorant (e.g., carbon black). In addition, the sealing composition of the first embodiment may contain a modifier (e.g., a silicone and silicone rubber). One type of colorant and modifier may be used alone, or two or more types thereof may be used in combination.

When conductive particles such as carbon black are used as the colorant, the conductive particles are preferably particles at a proportional content of 1% by mass or less having a particle diameter of 10 µm or more.

When the sealing composition of the first embodiment contains conductive particles, the proportional content of the conductive particles is preferably 3% by mass or less with respect to the total amount of the epoxy resin and the curing agent.

### <Sealing composition of second embodiment>

A sealing composition according to a second embodiment includes an epoxy resin, a curing agent, an inorganic filler, and an unfired hydrotalcite compound having a maximum particle size of 20 µm or less in which the molar ratio of Mg ions to Al ions (Mg/Al ratio) is 2.5 or higher.

The sealing composition of the second embodiment differs from the sealing composition of the first embodiment in that the first hydrotalcite compound is replaced with a second hydrotalcite compound. The sealing composition of the second embodiment has the same preferred aspect of each component such as the epoxy resin, curing agent, and inorganic filler as that of the sealing composition of the first embodiment, and other preferred aspects thereof are the same as those the sealing composition of the first embodiment.

The sealing composition of the second embodiment includes the second hydrotalcite compound having the maximum particle size of 20 µm or less in the particulate form and a Mg/Al ratio of 2.5 or higher. When the Mg/Al ratio of the second hydrotalcite compound is 2.5 or higher, and thus the ion trapping effect is improved. A semiconductor device manufactured using the sealing composition of the second embodiment has the second hydrotalcite compound with the maximum particle size of 20 µm or less in the particulate form and improved dispersibility in the sealing composition, and it is presumed that, when the sealing composition is prepared as a cured product, the probability of collision between anions such as chloride ions and the second hydrotalcite compound increases, which leads to an improved ion trapping effect, and thus the semiconductor device has excellent moisture resistance reliability in a bias-applied state.

### (Second hydrotalcite compound)

The sealing composition of the second embodiment includes the second hydrotalcite compound.

The second hydrotalcite compound is an unfired hydrotalcite compound having a maximum particle size of 20 µm or less in the present disclosure. The lower limit of the maximum particle size of the second hydrotalcite compound is not particularly limited.

Moreover, preferred forms of the second hydrotalcite compound are the same as those of the first hydrotalcite compound described above.

From the viewpoint of enhancing the ion trapping effect, the second hydrotalcite compound has a molar ratio (Mg/Al) between Mg ions and Al ions is preferably 3.0 or higher, more preferably 3.2 or higher, and even more preferably 3.5 or higher. An upper limit of the Mg/Al ratio is not particularly limited, and for example, may be 4.0 or less.

The second hydrotalcite compound is preferably an unfired hydrotalcite compound represented by the following general formula (3).

Mg_{1-y}Al_{y}(OH)₂(CO₃)_{y/2} · nH₂O General formula (3)

[In the formula (1), y and n each represent an independent positive number, and the value of (1-y/y) is 3.0 or greater]

In general formula (1), y represents a positive number indicating an amount of Mg substituted with Al, and 0 < y < 0.25 is preferred, and 0.2 ≤ x ≤ 0.25 is more preferred. n is a positive number equal to or greater than zero.

### <Production method for sealing compositions of first and second embodiments>

A production method for the sealing compositions of the first and second embodiments is not particularly limited, and a known method can be employed. For example, it can be produced by sufficiently mixing a mixture of raw materials in a predetermined blending amount with a mixer or the like, kneading it with a hot roll, an extruder or the like, and subjecting the mixture to cooling, pulverization, or the like. A state of the sealing composition is not particularly limited, and may be powder, solid, liquid, or the like.

### <Semiconductor device>

A semiconductor device of the present disclosure includes an element and a cured product of the sealing composition of the first or second embodiment that seals the element.

A method for sealing the element (electronic component) using the sealing compositions of the first and second embodiments is not particularly limited, and a known method can be applied. For example, low-pressure transfer molding is generally used, but injection molding, compression molding, cast molding, and the like may also be used.

The semiconductor device of the present disclosure has excellent humidity resistance reliability in a bias-applied state, and tends to mitigate the occurrence of a leakage defect, an inter-wire short-circuit defect, a wire-open defect, and the like. Furthermore, even if the semiconductor device includes copper wires, it is possible to curb corrosion of the copper wires and an increase in resistance. Therefore, the semiconductor device of this embodiment is suitable as an integrated circuit (IC), a largescale integration (LSI), or the like.

Furthermore, when a hydrotalcite compound having a large maximum particle size is present in a cured resin product, the releasability of the cured resin product from the mold tends to deteriorate, and the continuous moldability tends to be worse. On the other hand, deterioration of continuous moldability can be mitigated by using a hydrotalcite compound having a maximum particle size of 20 µm or less. In addition, since the maximum size of the hydrotalcite compound is reduced and the dispersibility is improved, a stain (segregation, etc.) on the package surface after molding can be curbed.

### [Examples]

Although examples of the present invention will be described below, the present invention is not limited thereto. In addition, numerical values in the table mean "parts by mass" unless otherwise specified. In addition, the blanks in Tables 1 to 8 mean unblended, unmeasured, or unevaluated.

### (Examples 1 to 17 and comparative examples 1 to 40)

After premixing (dry blending) the materials having the formulations shown in Tables 1 to 8, they were kneaded in a twin-screw kneader (internal temperature: about 100°C). The kneaded mixture was cooled and pulverized to produce a powdery sealing composition.

Details of the materials in Table 1 to 8 are as follows.

### (Epoxy resin)

E1: Biphenyl-type epoxy resin, epoxy equivalent of 192 g/eq
E2: Diphenylmethane-type epoxy resin (bisphenol-type epoxy resin), epoxy equivalent of 190 g/eq
E3: A mixture of 4,4'-biphenyldiylbis(glycidyl ether) and 3,3',5,5'-tetramethyl-4,4'-bis(glycidyloxy)-1,1'-biphenyl (mass ratio of 1:1), epoxy equivalent of 170 to 180 g/eq, softening point of 105°C
E6: Methoxynaphthalene/cresol formaldehyde co-condensation-type epoxy resin, epoxy equivalent of 250 g/eq, softening point of 58°C
E7: Triphenylmethane-type epoxy resin, epoxy equivalent of 170 g/eq

### (Curing agent)

H1: Novolac-type phenolic resin, hydroxyl equivalent of 103 g/eq to 107 g/eq, softening point of 67°C to 75°C
H2: Ortho-cresol novolac resin, hydroxyl equivalent of 116 g/eq, softening point of 65°C
H3: Novolac-type phenolic resin, hydroxyl equivalent of 167 g/eq to 179 g/eq, softening point of 61°C to 6°C
H4: Phenol aralkyl resin, hydroxyl equivalent of 205 g/eq
H5: Biphenyl aralkyl resin, hydroxyl equivalent of 164 g/eq to 168 g/eq, softening point of 58°C to 65°C
H6: Triphenylmethane-type phenol resin, hydroxyl equivalent of 95 g/eq to 105 g/eq, softening point of 105°C to 115°C
H7: Trisphenylmethane-type phenol resin, hydroxyl equivalent of 100 g/eq, softening point of 83°C

### (Curing accelerator)

HA1: Addition reactant of tributylphosphine and 1,4-benzoquinone
HA2: Addition reactant of triphenylphosphine and 1,4-benzoquinone

### (Coupling agent)

CPL1: N-phenyl-3-aminopropyltrimethoxysilane
CPL3: 3-Glycidoxypropyltrimethoxysilane
CPL6: Methacryloxy octyltrimethoxysilane

### (Wax)

Wax1: Montanic acid ester wax

### (Colorant)

Carl: Carbon black

### (Ion trapping agent)

HT1: Unfired hydrotalcite compound having a maximum particle size of 20 µm or less (Mg/Al = 3.5)
HT2: Unfired hydrotalcite compound having a maximum particle size of 20 µm or less (Mg/Al = 3.0)
HT3: Unfired hydrotalcite compound having a maximum particle size of 20 µm or less (Mg/Al = 2.25)
HT4: Unfired hydrotalcite compound having a maximum particle size of 20 µm or less (Mg/Al = 2.15)
HT5: Unfired hydrotalcite compound having a maximum particle size exceeding 20 µm (Mg/Al = 3.0)

### (Additive)

Flame retardant: Phosphorus flame retardant

### Silicone

### (Inorganic filler)

Si1: Spherical silica with an average particle size (D50) of 0.5 µm
Si2: Spherical silica with an average particle size (D50) of 19.9 µm
Al1: Alumina particles with an average particle size (D50) of 0.4 µm
Al3: Alumina particles with an average particle size (D50) of 12 µm

A semiconductor element was sealed by using a sealing composition obtained as above with a transfer molding machine under the conditions of a mold temperature of 175°C to 180°C, a molding pressure of 6.9 MPa, and a curing time of 90 seconds, and then a specimen to be used for highly accelerated temperature and humidity stress test (HAST) evaluation was prepared. The specimen had pads (Al:Si:Cu = 98.9%:0.8%:0.3%, a width of 60 µm) as electrodes and pure copper wires (diameter of 20 µm) as wires.

### (HAST test method)

The prepared specimen was placed in a high-temperature and high-humidity tank in an atmosphere at 130°C and a humidity of 85%, had a voltage of 5 V applied thereto, and was kept in the tank for a total of 24 hours, 48 hours, 96 hours, 168 hours, 336 hours, 504 hours, and 600 hours to perform a HAST test. Electrical characteristics were evaluated after the above times elapsed, and when the increase rate of electrical resistance value exceeded 150% (1.5 times the initial value) on average, it was determined to be NG (that is, defective). Six packages were used for one evaluation material.

The results of the HAST tests are shown in Tables 1 to 7. Each example in which HT1 or HT2 was used exhibited better HAST test results than in each comparative example with the same epoxy resin composition.

### (Evaluation of extract)

50 g of ion-exchanged water and 5 g of pulverized powder of a prepared sealing composition were placed in a pressure-resistant vessel, the ion concentration of the extract obtained by leaving the above materials at 121°C under 2 atmospheres for 20 hours was measured by using ion chromatography, and the pH of the extract was further measured.

The results are shown in Tables 1 to 7. The chloride ion concentration in the measurement of the extract was lower in each example in which HT1 or HT2 was used than in each comparative example, indicating that the ion trapping effect was excellent.

### (Evaluation of stain on PKG surface)

A test piece obtained by sealing a semiconductor element with a sealing composition as described above was visually observed to confirm the presence or absence of stain on a package (PKG) surface. The evaluation results are shown in Tables 1 to 7. Although the PKG surfaces of some comparative examples were stained, the PKG surface of each example was not stained.

### (Evaluation of continuous moldability)

The occurrence of sticking, voids and stain/flow marks on the package surface was evaluated as follows.

### <<Evaluation of sticking>>

A 2.2 mm × 3.2 mm × 0.37 mm small outline package (SOP) was prepared as an evaluation package, molding was continuously performed at 175°C for 90 seconds, and sticking was evaluated based on the following criteria.

### - Evaluation criteria-

A No sticking occurred on the package surface after 800 shots were molded.
B Sticking occurred on the package surface after 800 shots or less of molding.

### <<Evaluation of voids>>

A 1.5 mm × 2.6 mm × 0.37 mm small outline package (SOP) was prepared as an evaluation package, molding was continuously performed at 175°C for 90 seconds, and sticking was evaluated based on the following criteria.

### - Evaluation criteria-

A No voids were generated on the package surface after 300 shots of molding.
B Voids were generated on the package surface after 300 shots or less of molding.

### «Evaluation of stain/flow mark»

A 10.0 mm × 10.0 mm × 0.37 mm ball grid array (BGA) was prepared as an evaluation package, and molding was continuously performed at 175°C for 90 seconds, and stain/flow mark evaluation was performed based on the following criteria.

### - Evaluation criteria-

A No stains or flow marks occurred on the package surface after 300 shots of molding.
B At least one of stains and flow marks occurred on the package surface after 300 shots or less of molding.

The evaluation results are shown in Table 8. Although continuous moldability was evaluated to be poor in comparative example 40, continuous moldability was evaluated to be good in examples 16 and 17.

**[Table 1]**

| | | Example 1 | Example 2 | Example 3 | Example 4 | Example 5 | Example 6 |
|---|---|---|---|---|---|---|---|
| Epoxy resin | E1 | 30 | 30 | 30 | 30 | 30 | 30 |
| | E3 | 70 | 70 | 70 | 70 | 70 | 70 |
| Curing agent | H1 | 60 | | | | | |
| | H2 | | 65 | | | | |
| | H3 | | | 100 | | | |
| | H4 | | | | 112 | | |
| | H5 | | | | | 94 | |
| | H7 | | | | | | 59 |
| Curing accelerator | HA1 | 3.5 | 3.3 | 3.7 | 5.1 | 4.7 | 3.63 |
| Coupling agent | CPL6 | 7 | 7 | 7 | 7 | 7 | 7 |
| Wax | Waxl | 3 | 3 | 3 | 3 | 3 | 3 |
| Colorant | Carl | 3 | 3 | 3 | 3 | 3 | 3 |
| Ion trapping agent | HT1 | 5 | 5 | 5 | 5 | 5 | 5 |
| Inorganic filler | All | 237 | 244 | 288 | 307 | 283 | 236 |
| | A13 | 2435 | 2507 | 2956 | 3153 | 2908 | 2422 |
| | Vol.% | 82 | 82 | 82 | 82 | 82 | 82 |
| Extract | pH | 6.32 | 6.5 | 6.88 | 6.8 | 6.54 | 6.43 |
| | Cl⁻ | 7.3 | 8 | 9.1 | 9.8 | 9.5 | 9.2 |
| HAST | 24h | OK | OK | OK | OK | OK | OK |
| | 48h | OK | OK | OK | OK | OK | OK |
| | 96h | OK | OK | OK | OK | OK | OK |
| | 168h | OK | OK | OK | OK | OK | OK |
| | 336h | OK | OK | OK | OK | OK | OK |
| | 504h | OK | OK | OK | OK | OK | OK |
| Stain on PKG surface (surface agglomerate) | Present/absent | Absent | Absent | Absent | Absent | Absent | Absent |

**[Table 2]**

| | | Comparative example 1 | Comparative example 2 | Comparative example 3 | Comparative example 4 | Comparative example 5 | Comparative example 6 | Comparative example 7 | Comparative example 8 | Comparative example 9 |
|---|---|---|---|---|---|---|---|---|---|---|
| Epoxy resin | E1 | 30 | 30 | 30 | 30 | 30 | 30 | 30 | 30 | 30 |
| | E3 | 70 | 70 | 70 | 70 | 70 | 70 | 70 | 70 | 70 |
| Curing agent | H1 | 60 | 60 | 60 | | | | | | |
| | H2 | | | | 65 | 65 | 65 | | | |
| | H3 | | | | | | | 100 | 100 | 100 |
| | H4 | | | | | | | | | |
| | H5 | | | | | | | | | |
| | H7 | | | | | | | | | |
| Curing accelerator | HA1 | 3.5 | 3.5 | 3.5 | 3.3 | 3.3 | 3.3 | 3.7 | 3.7 | 3.7 |
| Coupling agent | CPL1 | | 7 | | | 7 | | | 7 | |
| | CPL3 | | | | | | | | | |
| | CPL6 | 7 | | 7 | 7 | | 7 | 7 | | 7 |
| Wax | Waxl | 3 | 3 | 3 | 3 | 3 | 3 | 3 | 3 | 3 |
| Colorant | Carl | 3 | 3 | 3 | 3 | 3 | 3 | 3 | 3 | 3 |
| Ion trapping agent | HT3 | | | 5 | | | 5 | | | 5 |
| | HT5 | 5 | 5 | | 5 | 5 | | 5 | 5 | |
| Inorganic filler | Sil | | | | | | | | | |
| | Si2 | | | | | | | | | |
| | All | 237 | 237 | 237 | 244 | 244 | 244 | 288 | 288 | 288 |
| | A13 | 2435 | 2435 | 2435 | 2507 | 2507 | 2507 | 2956 | 2956 | 2956 |
| | Vol% | 82 | 82 | 82 | 82 | 82 | 82 | 82 | 82 | 82 |
| Extract | pH | 6.61 | | | 6.64 | 6.63 | | 6.94 | | |
| | Cl- | 20 | 17 | 18 | 23 | 18.1 | 20 | 22.2 | 21.2 | 19.8 |
| HAST | 24h | OK | OK | OK | OK | OK | OK | OK | OK | OK |
| | 48h | OK | OK | OK | OK | OK | OK | OK | OK | OK |
| | 96h | OK | OK | OK | OK | OK | OK | OK | OK | OK |
| | 168h | OK | OK | NG | OK | OK | NG | OK | OK | NG |
| | 336h | OK | OK | | OK | OK | | OK | OK | |
| | 504h | NG | NG | | NG | NG | | NG | NG | |
| Stain on PKG surface (surface agglomerate) | Present/Absent | Present | Present | Absent | Present | Present | Absent | Present | Present | Absent |

**[Table 3]**

| | | Comparative example 10 | Comparative example 11 | Comparative example 12 | Comparative example 13 | Comparative example 14 | Comparative example 15 | Comparative example 16 | Comparative example 17 | Comparative example 18 |
|---|---|---|---|---|---|---|---|---|---|---|
| Epoxy resin | E1 | 30 | 30 | 30 | 30 | 30 | 30 | 30 | 30 | 30 |
| | E3 | 70 | 70 | 70 | 70 | 70 | 70 | 70 | 70 | 70 |
| Curing agent | H1 | | | | | | | | | |
| | H2 | | | | | | | | | |
| | H3 | | | | | | | | | |
| | H4 | 112 | 112 | 112 | | | | | | |
| | H5 | | | | 94 | 94 | 94 | | | |
| | H7 | | | | | | | 59 | 59 | 59 |
| Curing accelerator | HA1 | 5.1 | 5.1 | 5.1 | 4.7 | 4.7 | 4.7 | 3.63 | 3.63 | 3.63 |
| Coupling agent | CPL1 | | 7 | | | 7 | | | 7 | |
| | CPL3 | | | | | | | | | |
| | CPL6 | 7 | | 7 | 7 | | 7 | 7 | | 7 |
| Wax | Waxl | 3 | 3 | 3 | 3 | 3 | 3 | 3 | 3 | 3 |
| Colorant | Carl | 3 | 3 | 3 | 3 | 3 | 3 | 3 | 3 | 3 |
| Ion trapping agent | HT3 | | | 5 | | | 5 | | | 5 |
| | HT5 | 5 | 5 | | 5 | 5 | | 5 | 5 | |
| Inorganic filler | Sil | | | | | | | | | |
| | Si2 | | | | | | | | | |
| | All | 307 | 307 | 307 | 283 | 283 | 283 | 236 | 236 | 236 |
| | Al3 | 3153 | 3153 | 3153 | 2908 | 2908 | 2908 | 2422 | 2422 | 2422 |
| | Vol% | 82 | 82 | 82 | 82 | 82 | 82 | 82 | 82 | 82 |
| Extract | pH | 6.77 | | | 6.7 | | | 6.85 | | |
| | Cl⁻ | 21.8 | 19.9 | 18.7 | 24.2 | 22.4 | 20 | 31 | 29.3 | 28 |
| HAST | 24h | OK | OK | OK | OK | OK | OK | OK | OK | OK |
| | 48h | OK | OK | OK | OK | OK | OK | OK | OK | OK |
| | 96h | OK | OK | OK | OK | OK | OK | OK | OK | OK |
| | 168h | OK | OK | NG | OK | OK | NG | OK | OK | NG |
| | 336h | OK | OK | | OK | OK | | OK | OK | |
| | 504h | NG | NG | | NG | NG | | NG | NG | |
| Stain on PKG surface (surface agglomerate) | Present/Absent | Present | Present | Absent | Present | Present | Absent | Present | Present | Absent |

**[Table 4]**

| | | Example 7 | Example 8 | Example 9 | Example 10 | Example 11 | Example 12 |
|---|---|---|---|---|---|---|---|
| Epoxy resin | E1 | 50 | 50 | 50 | 50 | 50 | 50 |
| | E7 | 50 | 50 | 50 | 50 | 50 | 50 |
| Curing agent | H1 | 59 | | | | | |
| | H2 | | 65 | | | | |
| | H3 | | | 97 | | | |
| | H4 | | | | 111 | | |
| | H5 | | | | | 93 | |
| | H6 | | | | | | 58 |
| Curing accelerator | HA1 | 2.2 | 2.07 | 2.33 | 3.21 | 2.95 | 2.2 |
| Coupling agent | CPL1 | 7 | 7 | 7 | 7 | 7 | 7 |
| Wax | Waxl | 3 | 3 | 3 | 3 | 3 | 3 |
| Colorant | Carl | 3 | 3 | 3 | 3 | 3 | 3 |
| Ion trapping agent | HT1 | 5 | 5 | 5 | 5 | 5 | 5 |
| Inorganic filler | Sil | 143 | 147 | 173 | 184 | 170 | 142 |
| | Si2 | 1394 | 1436 | 1691 | 1803 | 1661 | 1385 |
| | Vol% | 82 | 82 | 82 | 82 | 82 | 82 |
| Extract | pH | 6.51 | 6.43 | 6.67 | 6.63 | 6.7 | 6.73 |
| | Cl⁻ | 9.9 | 9.2 | 8.3 | 7.8 | 9 | 8 |
| HAST | 24h | OK | OK | OK | OK | OK | OK |
| | 48h | OK | OK | OK | OK | OK | OK |
| | 96h | OK | OK | OK | OK | OK | OK |
| | 168h | OK | OK | OK | OK | OK | OK |
| | 336h | OK | OK | OK | OK | OK | OK |
| | 504h | OK | OK | OK | OK | OK | OK |
| | 600h | OK | OK | OK | OK | OK | OK |
| Stain on PKG surface surface agglomerate) | Present/Absent | Absent | Absent | Absent | Absent | Absent | Absent |

**[Table 5]**

| | | Comparative example 19 | Comparative example 20 | Comparative example 21 | Comparative example 22 | Comparative example 23 | Comparative example 24 | Comparative example 25 | Comparative example 26 | Comparative example 27 | Comparative example 28 | Comparative example 29 | Comparative example 30 |
|---|---|---|---|---|---|---|---|---|---|---|---|---|---|
| Epoxy resin | E1 | 50 | 50 | 50 | 50 | 50 | 50 | 50 | 50 | 50 | 50 | 50 | 50 |
| | E7 | 50 | 50 | 50 | 50 | 50 | 50 | 50 | 50 | 50 | 50 | 50 | 50 |
| Curing agent | H1 | 59 | 59 | | | | | | | | | | |
| | H2 | | | 65 | 65 | | | | | | | | |
| | H3 | | | | | 97 | 97 | | | | | | |
| | H4 | | | | | | | 111 | 111 | | | | |
| | H5 | | | | | | | | | 93 | 93 | | |
| | H6 | | | | | | | | | | | 58 | 58 |
| Curing accelerator | HA 1 | 2.2 | 2.2 | 2.07 | 2.07 | 2.33 | 2.33 | 3.21 | 3.21 | 2.95 | 2.95 | 2.2 | 2.2 |
| Coupling agent | CPL1 | 7 | 7 | 7 | 7 | 7 | 7 | 7 | 7 | 7 | 7 | 7 | 7 |
| Wax | Waxl | 3 | 3 | 3 | 3 | 3 | 3 | 3 | 3 | 3 | 3 | 3 | 3 |
| Colorant | Carl | 3 | 3 | 3 | 3 | 3 | 3 | 3 | 3 | 3 | 3 | 3 | 3 |
| Ion trapping agent | HT4 | 5 | | 5 | | 5 | | 5 | | 5 | | 5 | |
| | HT5 | | 5 | | 5 | | 5 | | 5 | | 5 | | 5 |
| Inorganic filler | Sil | 143 | 143 | 147 | 147 | 173 | 173 | 184 | 184 | 170 | 170 | 142 | 142 |
| | Si2 | 1394 | 1394 | 1436 | 1436 | 1691 | 1691 | 1803 | 1803 | 1661 | 1661 | 1385 | 1385 |
| | Vol% | | 82 | | 82 | | 82 | | 82 | | 82 | | 82 |
| Extract | pH | | 6.51 | | 6.43 | | 6.67 | | 6.63 | | 6.7 | | 6.73 |
| | Cl⁻ | 16.5 | 17.8 | 13.8 | 13 | 14 | 13.1 | 13.5 | 12.2 | 14 | 14.4 | 17.2 | 18.6 |
| HAST | 24h | OK | OK | OK | OK | OK | OK | OK | OK | OK | OK | OK | OK |
| | 48h | OK | OK | OK | OK | OK | OK | OK | OK | OK | OK | OK | OK |
| | 96h | OK | OK | OK | OK | OK | OK | OK | OK | OK | OK | OK | OK |
| | 168h | OK | OK | OK | OK | OK | OK | OK | OK | OK | OK | OK | OK |
| | 336h | NG | OK | NG | OK | NG | OK | NG | OK | NG | OK | NG | OK |
| | 504h | | NG | | NG | | NG | | NG | | NG | | NG |
| Stain on PKG surface (surface agglomerate) | Present/Absent | Absent | Present | Absent | Present | Absent | Present | Absent | Present | Absent | Present | Absent | Present |

**[Table 6]**

| | | Example 13 | Example 14 | Comparative example 31 | Comparative example 32 | Comparative example 33 | Comparative example 34 |
|---|---|---|---|---|---|---|---|
| Epoxy resin | E1 | 50 | 50 | 50 | 50 | 50 | 50 |
| | E2 | 50 | 50 | 50 | 50 | 50 | 50 |
| Curing agent | H4 | 52 | 52 | 52 | 52 | 52 | 52 |
| | H6 | 27 | 27 | 27 | 27 | 27 | 27 |
| Curing accelerator | HA1 | 3.24 | 3.24 | 3.24 | 3.24 | 3.24 | 3.24 |
| Coupling agent | CPL1 | 7 | 7 | 7 | 7 | 7 | 7 |
| Wax | Waxl | 3 | 3 | 3 | 3 | 3 | 3 |
| Colorant | Carl | 3 | 3 | 3 | 3 | 3 | 3 |
| Ion trapping agent | HT1 | | 5 | | | | |
| | HT2 | 5 | | | | | |
| | HT3 | | | | 5 | | |
| | HT4 | | | | | 5 | |
| | HT5 | | | | | | 5 |
| Inorganic filler | Sil | 130 | 130 | 130 | 130 | 130 | 130 |
| | Si2 | 1272 | 1272 | 1272 | 1272 | 1272 | 1272 |
| | Vol% | 79 | 79 | 79 | 79 | 79 | 79 |
| Extract | pH | 6.25 | 6.01 | 4.2 | 5.97 | 5.98 | 6.27 |
| | Cl- | 9.7 | 9.2 | 18.9 | 22.3 | 23.9 | 16.5 |
| HAST | 24h | OK | OK | NG | OK | OK | OK |
| | 48h | OK | OK | | OK | OK | OK |
| | 96h | OK | OK | | NG | NG | OK |
| | 168h | OK | OK | | | | OK |
| | 336h | OK | OK | | | | NG |
| | 504h | NG | OK | | | | |
| Stain on PKG surface (surface agglomerate) | Present/Absent | Absent | Absent | Absent | Absent | Absent | Present |

**[Table 7]**

| | | Example 15 | Comparative example 35 | Comparative example 36 | Comparative example 37 | Example 16 | Comparative example 38 |
|---|---|---|---|---|---|---|---|
| Epoxy resin | E1 | 100 | 100 | 100 | 100 | 30 | 30 |
| | E6 | | | | | 70 | 70 |
| Curing agent | H3 | | | | | 77 | 77 |
| | H4 | 33 | 33 | 33 | 33 | | |
| | H7 | 40 | 40 | 40 | 40 | | |
| Curing accelerator | HA1 | 3.9 | 3.9 | 3.9 | 3.9 | | |
| | HA2 | | | | | 5 | 5 |
| Coupling agent | CPL1 | 4.5 | 4.5 | 4.5 | 4.5 | 3 | 3 |
| | CPL3 | | | | | 4 | 4 |
| Wax | Waxl | 3 | 3 | 3 | 3 | 3 | 3 |
| Colorant | Carl | 3 | 3 | 3 | 3 | 3 | 3 |
| Ion trapping agent | HT1 | 10 | | | | 3 | |
| | HT3 | | | 10 | | | 3 |
| | HT5 | | | | 10 | | |
| Additive | Flame retardant | | | | | 10 | 10 |
| | Silicone | | | | | 10 | 10 |
| Inorganic filler | Sil | 139 | 139 | 139 | 139 | | |
| | Si2 | 1254 | 1254 | 1254 | 1254 | 1670 | 1670 |
| | Vol% | 79 | 79 | 79 | 79 | 80 | 80 |
| Extract | pH | 6.69 | 4.08 | 6.15 | 6.54 | 5.86 | 5.1 |
| | Cl⁻ | 9.6 | 21.3 | 24.3 | 15 | 8.3 | 14 |
| HAST | 24h | OK | NG | OK | OK | | |
| | 48h | OK | | OK | OK | | |
| | 96h | OK | | NG | OK | | |
| | 168h | OK | | | OK | | |
| | 336h | OK | | | OK | | |
| | 504h | OK | | | NG | | |
| Stain on PKG surface (surface agglomerate) | Present/Absent | Absent | Absent | Absent | Present | Absent | Absent |

**[Table 8]**

| | | Example 16 | Example 17 | Comparative example 38 | Comparative example 39 | Comparative example 40 |
|---|---|---|---|---|---|---|
| Epoxy resin | E1 | 30 | 30 | 30 | 30 | 30 |
| | E6 | 70 | 70 | 70 | 70 | 70 |
| Curing agent | H3 | 77 | 77 | 77 | 77 | 77 |
| Curing accelerator | HA2 | 5 | 5 | 5 | 5 | 5 |
| Coupling agent | CPL1 | 3 | 3 | 3 | 3 | 3 |
| | CPL3 | 4 | 4 | 4 | 4 | 4 |
| Wax | Waxl | 3 | 3 | 3 | 3 | 3 |
| Colorant | Carl | 3 | 3 | 3 | 3 | 3 |
| Ion trapping agent | HT1 | 3 | | | | |
| | HT2 | | 3 | | | |
| | HT3 | | | 3 | | |
| | HT4 | | | | 3 | |
| | HT5 | | | | | 3 |
| Additive | Flame retardant | 10 | 10 | 10 | 10 | 10 |
| | Silicone | 10 | 10 | 10 | 10 | 10 |
| Inorganic filler | Si2 | 1670 | 1670 | 1670 | 1670 | 1670 |
| | Vol% | 80 | 80 | 80 | 80 | 80 |
| Evaluation of sticking | | A | A | A | A | B |
| Evaluation of voids | | A | A | A | A | B |
| Evaluation of stain/flow mark | | A | A | A | A | B |

The disclosure of Japanese Patent Laid-Open No. 2021-002322 filed on January 8, 2021 is incorporated herein by reference in its entirety.

All publications, patent applications, and technical standards mentioned in the present specification are to the same extent as if each individual publication, patent application and technical standard were specifically and individually noted to be incorporated herein by reference.

## Claims

1. A sealing composition comprising:
an epoxy resin;
a curing agent;
an inorganic filler; and
an unfired hydrotalcite compound in which a molar ratio of Mg ions to Al ions (Mg/Al) exceeds 3.0.

2. A sealing composition comprising:
an epoxy resin;
a curing agent;
an inorganic filler; and
an unfired hydrotalcite compound having a maximum particle size of 20 µm or less in which a molar ratio of Mg ions to Al ions (Mg/Al) is 2.5 or higher.

3. The sealing composition according to claim 2,
wherein the molar ratio of Mg ions to Al ions (Mg/Al) of the unfired hydrotalcite compound is 3.0 or higher.

4. The sealing composition according to claim 1,
wherein a maximum particle size of the unfired hydrotalcite compound is 20 µm or less.

5. The sealing composition according to any one of claims 1 to 4,
wherein an interlayer distance of ions in the unfired hydrotalcite compound is 7.7 Å or greater.

6. A semiconductor device comprising:
an element; and
a cured product of the sealing composition according to any one of claims 1 to 5 sealing the element.
